# EUROPEAN PATENT SPECIFICATION

(11) **EP 0 511 014 B1**
(45) Date of publication and mention of the grant of the patent: **21.08.1996**
(21) Application number: 92303738.6
(22) Date of filing: 24.04.1992
(51) Int. Cl.: H05K 7/06

(54) **Integrally molded printed circuit board and method of making the same**
Integrierend geformte gedruckte Schaltung und Verfahren zur Herstellung einer solchen
Carte de circuits imprimés moulée intégralement et procédé pour sa fabrication

(30) Priority: 25.04.1991 JP 95127/91; 26.04.1991 JP 96843/91
(43) Date of publication of application: 28.10.1992
(73) Proprietor: MITSUBISHI DENKI KABUSHIKI KAISHA, Tokyo (JP)
(72) Inventor: Kimura, Toshifumi, c/o Mitsubishi Denki K. Kaisha, 8-chome, Amagasaki-shi, Hyogo-ken (JP); Hamada, Osamu, c/o Mitsubishi Denki K. Kaisha, 8-chome, Amagasaki-shi, Hyogo-ken (JP); Kohashi, Masao, c/o Mitsubishi Denki K. Kaisha, 8-chome, Amagasaki-shi, Hyogo-ken (JP)
(74) Representative: Mounteney, Simon James

(56) References cited:
- GB-A- 2 208 333
- US-A- 3 838 094
- US-A- 4 460 537
- US-A- 4 688 152

## Description

### BACKGROUND OF THE INVENTION

### Field of the Invention

The present invention relates to a method of integrally molding a printed circuit board to an enclosure by the use of injection molding and the resulting product.

### Discussion of the Background

Printed circuit boards, also known as printed circuit boards, are conventionally mounted in enclosures with the use of screws, snaps, or other mechanical securing means. Until recently, the additional space occupied by the mechanical securing means did not pose a problem since the overall size of the structure was dictated more by the size of the electrical components mounted on the wiring board rather than by the space occupied by the mechanical mounting means. However, with the increasing miniaturization of electronics and the desire to manufacture smaller and smaller electronic devices to improve portability, the space consumed by mechanical attaching means has become a significant portion of the total overall dimensions of the device, in particular the thickness of the device. If the mechanical mounting means such as screws are used, then the enclosure must contain material having the suitable thickness to provide a substantial amount of material into which the screw may be inserted to hold the printed circuit board in place. Mechanical means including snaps, fasteners and the like also require a comparatively substantial thickness or volume in the enclosure to hold the associated mechanical latching means.

The use of adhesives, glues and the like have not been successfully used for several important reasons. First, in most instances the enclosures into which the printed circuit boards are mounted are made of thermoplastic resins which have a substantially different thermal expansion coefficient than does the printed circuit board which is typically manufactured of a thermoset resin or glass filled resin and is specifically designed not to have a substantial coefficient of thermal expansion. As a result of the mismatch between the coefficients of thermal expansion between the printed circuit board and the enclosure, the use of glues to attach printed circuit boards has not been successful since with the repeated expansion and contraction of the container through varying temperature cycles, the adhesive bond between the printed circuit board and the container is destroyed. Also, for the use of adhesive requires that the adhesive be applied across the entire face of a printed circuit board and not merely at the edges. This means that only one side of the printed circuit board can be used to mount electronic devices. It also means the printed circuit board can only be counted against a major surface of the container and can not be glued along the edges of the board and to the sides of a container. This precludes the use of both major surfaces of the printed circuit board from containing active electronic devices. It has become core and more conventional today to mount active devices on both surfaces of the printed circuit board so as to minimize overall container volume.

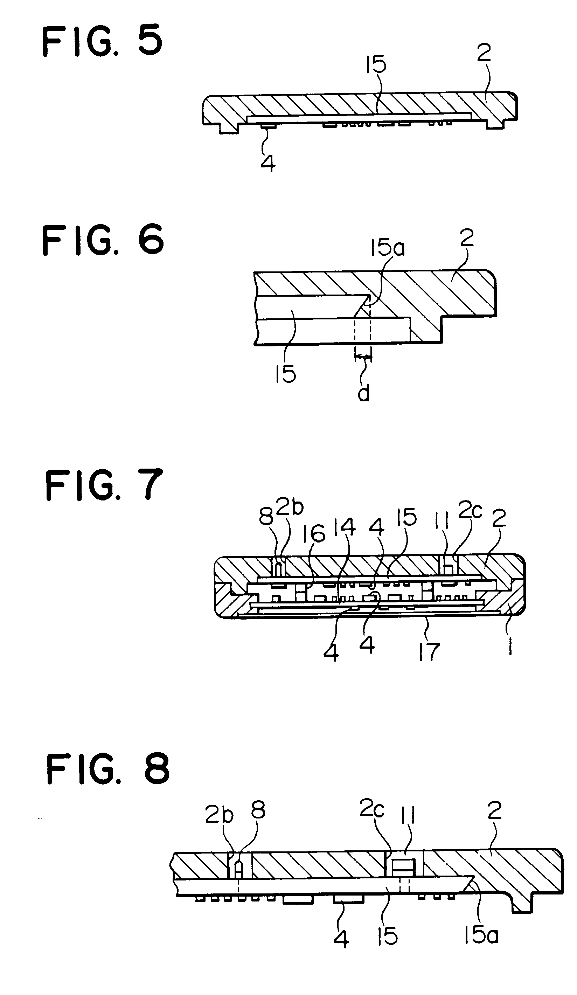

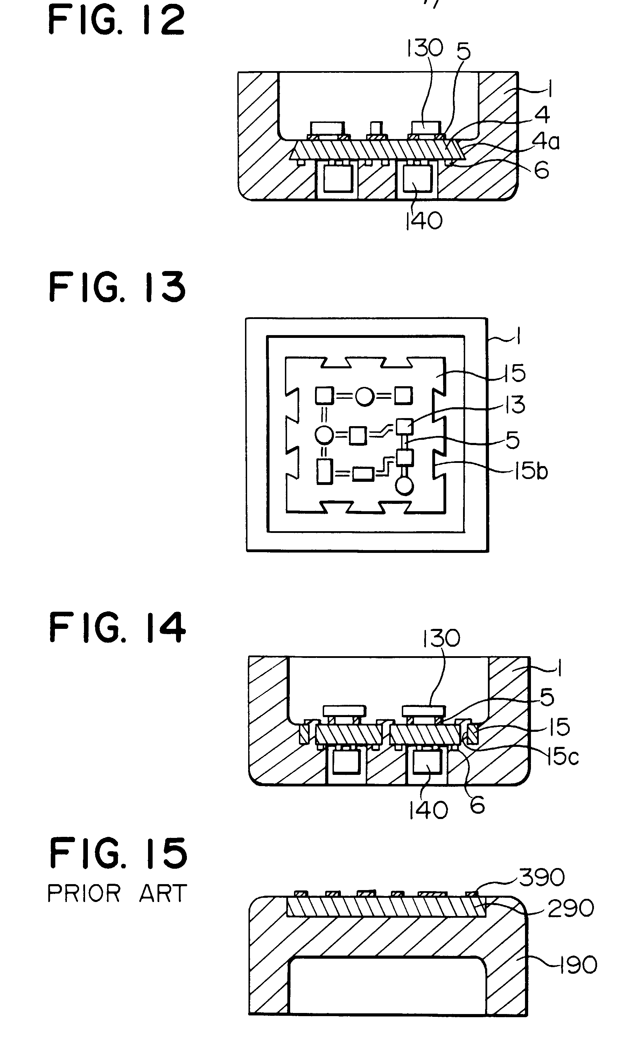

In Japanese Utility Model Publication 112085/1989 there has been suggested molding of the printed circuit board into a container as illustrated in Figure 15. In Figure 5, numeral 190 is the box body, in this instance a meter housing, item 290 is the printed circuit board which is integrally molded on the rear surface of the box body, and 390 represents a conductor circuit pattern formed on the surface of the printed circuit board 290. The technique of the Japanese Utility Model suffers from several important deficiencies. First, it provides for only one surface of the printed circuit board to carry active electronic devices thereby precluding the use of both major surfaces for active devices. Second, the technique of the Japanese Utility Model has not proven successful since the printed circuit board can over time become loosened or detached from the box body. The box body is manufactured of a thermoplastic resin which has a different thermal coefficient of expansion than does the circuit board. That is, the box body will expand or shrink to a much greater degree with changes in temperature than will the printed circuit board. So long as the temperature to which the box body is exposed does not vary significantly, the printed circuit board should remain tightly held in place. However, if the box body is exposed to significant temperature fluctuation such as from 0 to 35°C, then the printed circuit board could become detached from the box body as a result of the temperature fluctuations, especially at the high temperatures where the box body will expand substantially more than the printed circuit board thus offering the possibility of release of the printed circuit board from the box body.

Accordingly, there remains a need for a method of firmly attaching a printed circuit board to a container without the use of mechanical fasteners, bonding agent such as adhesives wherein it is possible to mount the board such that both surfaces may be used,to,mount active devices.

### SUMMARY OF THE INVENTION

It is an object of the present invention to provide a reliable method of integrally molding a printed circuit board into a container in which both surfaces of the board may be utilized for mounting active electronic components.

It is a further objective of the present invention to provide for a method of permanently assembling a thermoset printed circuit board to a container made of thermoplastic resin.

It is another object of the present invention to provide a technique for bonding printed circuit boards to containers or portions thereof trough the use of injection molding techniques.

It is yet another object of the invention to provide a method of assembling a printed circuit board to an enclosure such that a mechanical connection is formed between the circuit board and the enclosure during the molding of the enclosure.

It is yet a further object of the invention to provide an assembly of a printed circuit board and an enclosure connected by a mechanical connection formed during the molding of the enclosure.

The above, and other, objects are achieved according to an aspect of the present invention by a method of assembling a printed circuit board to an enclosure by the steps of positioning a printed circuit board in a mold, injection molding plastic resin into the mold to form an enclosure, wherein the circuit board is configured such that plastic flow during the injection molding step creates a mechanical locking engagement between the circuit board and the enclosure during the injection molding step, and removing the assembled circuit board and enclosure from the mold.

According to a further feature of the invention, at least a portion of the periphery of the circuit board is bevelled to form the mechanical locking engagement.

According to yet a further feature of the invention, the mechanical locking engagement is formed by at least a portion of the periphery of the circuit board being fitted in a groove of the enclosure by a depth greater than a maximum expected difference in thermal expansion between the enclosure and the circuit board.

According to yet a further feature of the invention, the circuit board has reversed notches into which the plastic flows to form the mechanical locking engagement.

According to yet a further feature of the invention, mold pieces are positioned against the circuit board in the mold such that openings for access to the circuit board are formed in the enclosure.

According to yet a further feature of the invention, the circuit board has holes into which plastic flows during the injection molding step to form the mechanical locking engagement.

According to yet a further feature of the invention, reinforcing ribs are formed in the enclosure during the molding step for reinforcing the circuit board.

The present invention is further carried out by an assembly of a circuit board and an enclosure, comprising a circuit board and a molded plastic enclosure molded to the circuit board. The circuit board and the enclosure have portions configured such that a mechanical locking engagement is formed between the circuit board and the enclosure during the molding of the enclosure.

The invention also provides an assembly as set out in Claim 17 or 18.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Figure 1 is a schematic sectional view of an assembly of two circuit boards in an enclosure in accordance with the present invention;
Figure 2 is a sectional view of a lower case of the enclosure supporting a circuit board;
Figure 3 corresponds to Figure 2 but shows electronic elements counted on the circuit board;
Figure 4 is a detail of a portion of the lower case at the mechanical connection between the enclosure and the circuit board, showing the depth of the groove into which the periphery of the circuit board fits;
Figure 5 corresponds to Figure 3 but shows an upper case supporting a circuit board having electronic elements thereon;
Figure 6 is a partial sectional view of a variant of an upper case;
Figure 7 corresponds to Figure 1 but shows another embodiment in which the upper case has openings for access to one of the circuit boards;
Figure 8 corresponds to Figure 6 but shows a circuit board mounted in the upper case in which the upper case has openings for access to the circuit board mounted therein;
Figure 9 shows another embodiment in which plural circuit boards are mounted at different surfaces of a case;
Figure 10 shows a prior art assembly of a circuit board and an enclosure;
Figure 11 shows a circuit board mounted in a mold in preparation for the molding of the enclosure;
Figure 12 shows a circuit board having molded thereto an enclosure formed in the mold of Figure 11;
Figure 13 shows a plan view of a further embodiment in which reverse taper notches in the periphery of the circuit board are filled with molded plastic material of the enclosure to form a mechanical connection;
Figure 14 shows a sectional view of a further embodiment in which holes in the circuit board are filled with molded plastic material to form a mechanical connection;
Figure 15 is a sectional view of a further prior art assembly;
Figure 16 is a plan view of yet a further embodiment in which the circuit board has holes for the mechanical connection and the enclosure has a reinforcing rib; and
Figure 16 A is a sectional view taken along line A-A of Figure 16.

### DESCRIPTION OF THE PREFERRED EMBODIMENTS

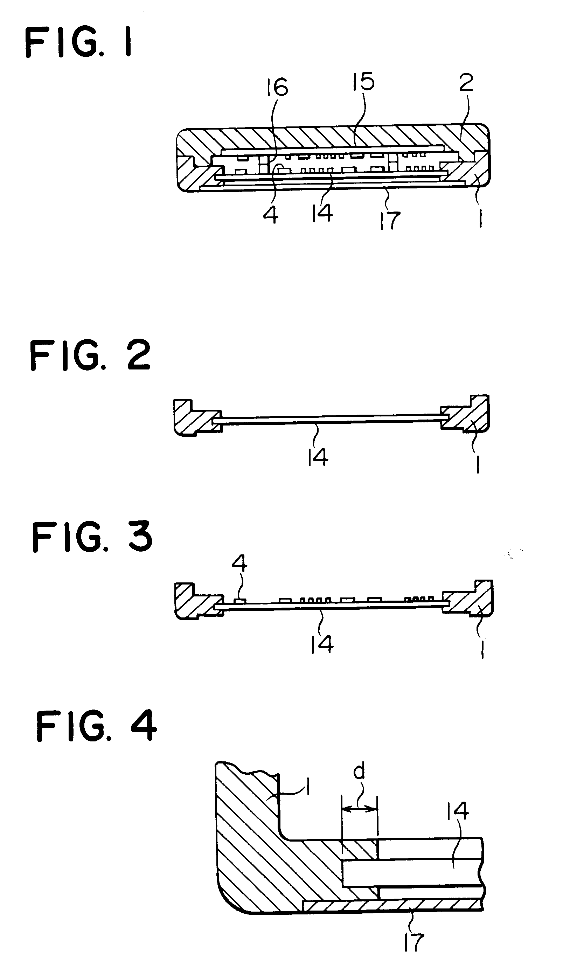

The box or container into which the printed circuit board is to be counted by injection molding the box or container around the printed circuit board will tend to have a greater thermal coefficient of thermal expansion than the board itself. Referring to figures 1-4, a description of the phenomenon which occurs as a result of thermal expansion will be given. the enclosure typically is formed of at least two parts, a lower case and an upper case which are joined together to produce the assembled electronic device such as cellular telephone or the like. In Figure 1 the upper case is designated with the numeral 2 and the lower case with the numeral 1. The printed circuit boards are shown as items 14 and 15 with the electronic parts generally designated by the numeral 4 while item 17 is a cover which could contain the input means for the device such as a keyboard or the like, or could simply be a protective cover.

Items 16 represent connectors for electrically connecting the wiring boards or printed circuit boards 14 and 15 together and are shown for illustrative purposes only. The upper and lower cases 1 and 2 tend to expand or contract with temperature changes to a significantly greater extent than will the generally temperature stable printed circuit boards. Thus, when exposed to elevated temperatures above room temperature during use, the two cases will tend to expand or pull away from the two circuit boards. In the case of circuit board 14, one or more edges of the circuit board could become completely loosened from the case if thermal expansion was sufficient that the case expanded to a greater extent than the depth d shown on Figure 4.

In the present invention this can be obviated during the molding process by designing the case such that the printed circuit board extends into each side of the case a distance greater than the total thermal expansion of the case over its expected temperature cycle. That is, in Figure 4, case 1 would be formed around circuit board 14 to a sufficient depth such that during the normal temperature cycle the total expansion of the case in either its width or its length would the less than the distance "d" shown in Figure 4. In this manner, a strong mechanical connection can be formed between the case and the printed circuit board.

With respect to the printed circuit board 15, as shown in Figure 6 the edge of the printed circuit board should be formed such that the face of the board containing the active electronic components, i.e., the top, has a smaller surface area than the back surface of the printed circuit board which is embedded in the plastic. By forming the bevelled edges 15a, the circuit board will be retained in the case by a mechanical connection at the corresponding bevelled edges of the case 2, even when the case undergoes thermal expansion, so long as the distance "d" shown on Figure 6 is greater than the linear expansion of the case in either the length or width directions. Since the length of the box is generally greater than the width of the box, the "d" dimension in the length direction should be greater than that in the width direction. The necessary depth "d" is readily calculated by utilizing the thermal coefficients of expansion for both the board and the case material. The "d" dimension should be at least as great as the difference between the thermal expansions of the two materials over the full extent of the temperature range to which the device is expected to be exposed to or designed to withstand.

The approach illustrated in Figures 1-4 is useful only where the wall thickness of the case is sufficiently substantial that the insertion of the printed circuit board into the wall will not result in excessive weakening of the wall structure. As illustrated in Figure 1, this technique finds applicability when the circuit board is to be inserted at a location where the case essentially terminates at a major surface. Using this technique, the case when the upper and lower halves are assembled is much thinner than with the prior art device.

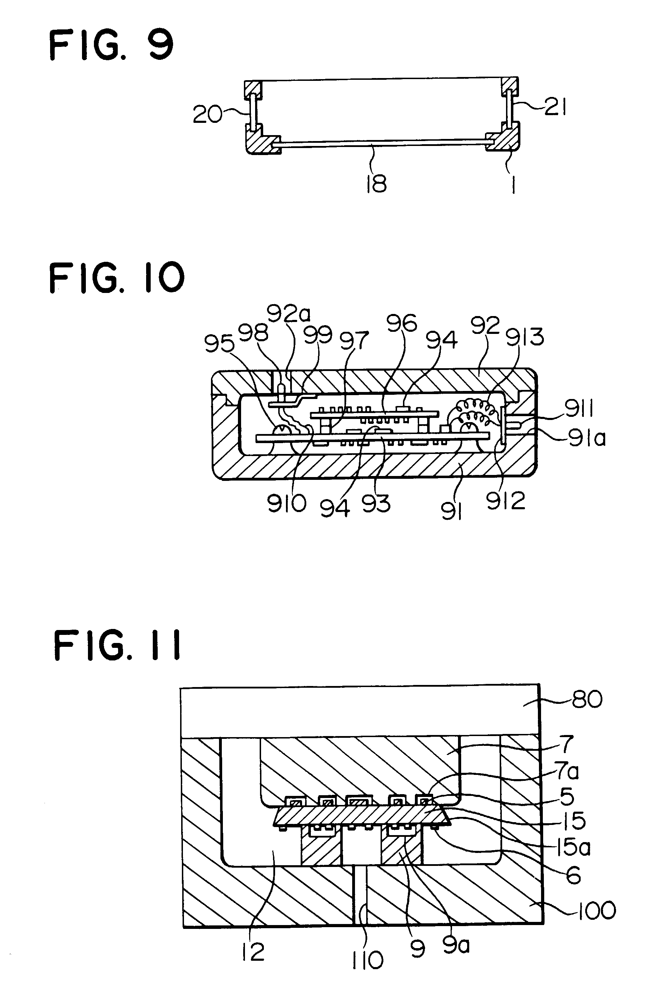

The conventional prior art techniques of attaching the wiring board through the use of screws or the like is illustrated in Figure 10. As can be seen in Figure 10, the structure necessary to accommodate the screws results in a substantially thicker case than does the structure illustrated in Figure 1. In Figure 10, numeral 91 represents the lower case and numeral 92 the upper case and openings 92a and 91a represent openings in the structure itself to accommodate devices such as switches 911 of LEDs 98. Item 912 is the mounting means for the switch on the inside of the case and element 99 is the mounting means for the LED also on the inside of the case. The screws 95 mount the two circuit boards 93 and 96 with active elements 94 thereon to the lower case 91. Connection between the two circuit boards is shown at 97 while connections to the various active devices mounted on the walls of the case are shown as 913 and 910 respectively. As can be seen in this device, a substantial amount of space is necessary to accommodate the separate elements.

In contrast, as illustrated in Figures 7 and 8 with the present technique it would be possible to directly mount both the switch and the diode on the printed circuit board 15 with openings 2b and 2c through the case 2 to provide the necessary access. The use of separate wiring leads and attachment means for both the diodes and switches as in conventional devices is avoided by the direct connection to the printed circuit board. Figure 8 shows an expanded view of Figure 7. The numerals correspond to the same parts as in Figure 1 with 2c representing the openings for the active devices 8 and 11, 8 for example being an LED and 11 a volume control switch. As can be seen, the arrangement in accordance with the present invention is far more compact than one according to the prior art as illustrated in Figure 10.

Figure 9 illustrates yet another possible embodiment of the present invention. In this embodiment, circuit boards are located not only on the major faces of the device but also in the sides, as evidenced by circuit boards 20 and 21 in addition to wiring board 18. In this embodiment essentially all surfaces of the case will contain circuit boards.

As can be seen from the figures, the walls into which the circuit boards are inserted must be comparatively thick to accommodate the results of thermal expansion and to provide the necessary strength to the case. Where it is desired to make the walls as thin as possible or to mount the circuit boards not in a major face of the case, but rather than in the middle, this would result in a thickening of the wall structure such that the minimum case size would not be achieved. Figure 13 illustrates a solution to this problem. In this case, the circuit board is provided with reverse taper openings or notches, i.e., these which are wider in the interior of the board than at the edge of the board.

In Figure 13 the edges of the board 15 having circuit elements 13 have opening 15b of trapezoidal shapes, however circular shapes or triangular shapes where the base of the triangle is located within the board and the apex towards the exterior of the board, or circular openings where the diameter of the circular opening lies within the body of the printed circuit board, may instead be used. In these instances, the walls need not be thick to restrain the board in the event of expansion or contraction but rather the flow of the plastic into the shaped openings during molding effectively locks the circuit board in place such that the walls of the device may remain thin throughout the major portion of the case and the board is locked in place.

The notches 15b form a mechanical locking of the printed circuit board with correspondingly shaped elements in the sides of the case. Thus, if the case expands as the result of thermal expansion, the plastic within the notches 15b restrains the printed circuit board in place, and even though the case has tended to move away from the board, the presence of plastic within the notches 15b acts as a mechanical lock on the board. The number of notches or size of notches used is not important so long as the stress imposed by the thermal expansion of the box does not exceed the strength of the plastic at the narrowest most portion or neck of the notch. Overstressing of the plastic could cause the plastic over time to undergo fatigue failure. This can be avoided by either making the neck fairly wide as illustrated in Figure in or by providing a large number of notches along the length and width of the printed circuit board. The number of notches necessary is determined by the neck size and the expected degree of thermal expansion. The shape and size of the notch is not critical so long as it is of size and shape such that it will lock the printed circuit board in place.

Figure 14 is an alternative technique for mechanically locking the printed circuit board onto a major surface of the case. As illustrated in Figure 14, the case 1 has openings for active devices 140 while other active devices 130 are on the opposite side of the board 15 having circuit pattern 5 facing inward. As is illustrated, the conductor circuit pattern 6 may be buried within the thermoplastic forming the case even though it generally is not desirable to incorporate active devices within the thermoplastic resin. In this instance, holes 15c have been drilled into the circuit board through which the plastic forming the case may flow during molding to form a pin having a flattened head. In this way, the pins formed in place serve to hold the circuit board in place even when undergoing thermal expansion.

Figure 11 illustrates the method by which one would form by injection molding the case around a printed circuit board and Figure 12 illustrates the finished device. In these figures, item 1 represents the container or box to hold the printed circuit board, item 15 is the printed circuit board itself, 15b is the bevel or tapered portion of the periphery the printed circuit board which serves to form the mechanical correction with the enclosure. Items 5 and 6 are the conductor circuit patterns on the board and items 130 and 140 are active electronic components. Item 12 is the open space into which the plastic will be injected typically through opening 110 in die 100. Item 7 is the corresponding die which has a top 80 and notches 7a around the conductor patterns 6 and 5 formed on the printed circuit board. Item 9 having notches 9a is shown as separate pieces, but may be integral with die 100. It forms molds around which the plastic will be injected to form the openings 2b or 2c through which active devices 140 can be accessed from the exterior or the box or form openings into which they will fit. After the plastic has been injection molded into the die and is hardened, the die is separated and the finished product is removed.

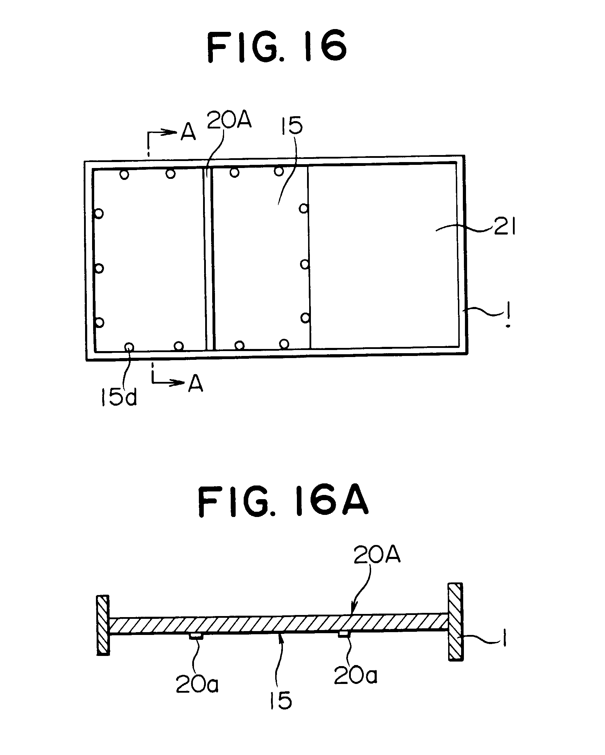

When the printed circuit board is not mounted against a major face of the case but is rather suspended from the side walls of the case, as illustrated in Figure 16, the printed circuit board may, prior to being mounted in the case be fully wired with the active devices are then joined to the case by the injection molding procedure. This procedure can be accomplished using conventional techniques. The advantage of this particular embodiment is ease of assembly since the printed circuit board may be fully assembled before being mounted into the case. A view of this is shown in Figure 16A illustrating a printed circuit board which has been mounted into the middle of a case rather than into either the top of the bottom.

In Figure 16, element 20A is a stiffening rib which is molded at the same time as case 1 is molded around printed circuit board 15. In this embodiment, the openings in the printed circuit board are of a general circular shape as shown in 15d and it is the injection molding of plastic into these openings during the formation of the case that locks the printed circuit board into place. In this specific embodiment, element 21 is a portion of the case which does not contain any printed circuit board elements. This may be either an opening or an injection molded surface onto which other devices are mounted, such as speakers or the like.

Figure 16A is a sectional view along line AA of Figure 16. As can be seen in this figure, the printed circuit board 15 extends only partway in the side walls of the case. The depth to which the printed circuit board extends into the case need only be sufficient to allow the flow of plastic during injection molded into the openings 15a. In this embodiment, rib 20A is bonded not only to the side case 1 but also to the printed circuit board 15 as a result of printed circuit board 15 containing openings through which the plastic forming the rib can flow in the form of pins, shown as 20a, such that the rib will perform a stiffening function with respect to the printed circuit board as well as protect the printed circuit board from deflection as by the overlying top of the case (not shown). Although pins 20a are shown as extending completely through and protruding beyond the lowest surface of the printed circuit board, they need not extend fully through the printed circuit board. In addition, the openings in the printed circuit board at which cooperate with the case to mechanically restrain the printed circuit board in place, may have either bevelled or unbevelled edges. That is, the top and bottom of these openings may be wider than the center portion in the printed circuit board.

The embodiment of Figure 16 can be readily manufactured using conventional injection molding techniques. The printed circuit board would be inserted into the mold used to form the case 1 in a fashion such that openings 15a were disposed within the die such that the thermoplastic resin comprising the case could flow during the forming process into the openings.

Although not illustrated, when surface mounted technology is used for mounting the active device on a printed circuit board, and only one side of the printed circuit board is used for this purpose, the reverse side which is generally smooth can function as one surface of a battery compartment thereby further decreasing the size of the device. This would find particular use in hand held calculators, cellular telephones and the like.

In the present embodiment, the thermoplastic resin which forms the case can be essentially any thermoplastic resin which may be molded. While essentially any thermoplastic resin may be used, it is generally preferable to use the so-called engineering plastics which tend to have excellent impact strengths and dimensional stability such as polybutylenetelephtalate (PBT) or polyphenylenesulfide (PPS). This results in a case which can withstand the substantial amount of abuse that many portable electronic components are subjected to including accidental dropping, exposure to moisture and the like.

The printed circuit boards are conventionally made from glass and impregnated resins, thermoset resins and combinations thereof. Essentially any printed circuit board may be mounted in accordance with the present technique. Engineering plastics which may be used include hybrid heat resistant resin (HHR), heat resistant glass fiber based epoxy resins such as FR-4, polyphenylene sulfide, high impact polystyrenes, polycarbonates, syndiotactic polystyrenes and the like. Other non-engineering thermoplastic resins such as polypropylene, polyethylene, may also be used if desired.

The casing may, for example, be 100mm x 150mm x 20mm. Exemplary molding conditions may be:
- Molding Temp.:: 200°C - 350°C.
- Injection Press.:: 200 kg/cm² - 1500 kg/cm².
- Die Temp.:: Room Temp. - 150°C.

Through the use of the present invention, it is possible to substantially reduce thickness of portable electronic devices to that essential to hold the active electronic components and any battery or other component parts. Since it is unnecessary to have separate mechanical attachment of the board to the case through the use of elements such as screws or the like. This technique allows the elimination of the use of screws without loss of strong mechanical attachment to the case such that the board will not become loose during routine use and vibration. Indeed, the present invention offers a substantial advantage over screws which, as a result of exposure to normal vibratory forces, after extended periods of time may become loose allowing the printed circuit board to move causing failure of the device.

Obviously, numerous modifications and variations of the present invention are possible in light of the above teachings. It is therefore to be understood that within the scope of the appended claims, the invention may be practiced otherwise than as specifically described herein.

## Claims

1. A method of assembling a printed circuit board to an enclosure, comprising the steps of:
positioning a printed circuit board in a mold;
injection molding a plastic resin into the mold to form an enclosure, wherein the circuit board is configured such that plastic. flow during the injection molding step creates a mechanical locking engagement between the circuit board and the enclosure; and
removing the assembled circuit board and enclosure from the mold.

2. The method of Claim 1 wherein at least a portion of the periphery of the circuit board is bevelled to form the mechanical locking engagement.

3. The method of Claim 1 wherein the mechanical locking engagement is formed by at least a portion of the periphery of the circuit board being fitted in a groove of the enclosure by a depth greater than a maximum expected difference in thermal expansion between the enclosure and the circuit board.

4. The method of Claim 1 wherein the circuit board has notches into which the plastic flows to form the mechanical locking engagement.

5. The method of Claim 4 wherein the notches have reverse tapers.

6. The method of Claim 1 including the step of positioning mold pieces against the circuit board in the mold such that openings for access to the circuit board are formed in the enclosure.

7. The method of Claim 1 wherein the circuit board has holes into which plastic flows during the injection molding step to form the mechanical locking engagement.

8. The method of Claim 7 including the step of forming reinforcing ribs in the enclosure during the molding step for reinforcing the circuit board.

9. An assembly of a circuit board and an enclosure, comprising:
a circuit board; and
a molded plastic enclosure molded to the circuit board,
wherein the circuit board and the enclosure have portions configured such that a mechanical locking engagement is formed between the circuit board and the enclosure during the molding of the enclosure.

10. The assembly of Claim 9 wherein said enclosure has a molded groove into which a portion of the periphery of the circuit board in fitted by a depth greater than a maximum expected difference in thermal expansion between the enclosure and the circuit board.

11. The assembly of Claim 9 wherein at least a portion of the periphery of the circuit board is bevelled to form the mechanical locking engagement.

12. The assembly of claim 9 wherein the circuit board has notches filled with plastic material of the enclosure to form the mechanical locking engagement.

13. The assembly of claim 12 wherein the notches have reverse tapers.

14. The assembly of claim 9 wherein the enclosure has molded openings to provide access to the circuit board.

15. The assembly of claim 9 wherein the circuit board has holes into which plastic flows during the injection molding step to form the mechanical locking engagement

16. The assembly of claim 15 wherein the enclosure includes molded reinforcing ribs for reinforcing the circuit board.

17. An assembly of two circuit boards and an enclosure, comprising:
first and second circuit boards opposing each other;
a plurality of electronic parts mounted to the opposed surfaces of the first and second circuit boards; and
a molded plastic enclosure having an upper case portion molded to the first circuit board and a lower case portion molded to the second circuit board,
wherein the first and second circuit boards and the upper and lower case portions of the enclosure have portions configured such that mechanical locking engagements are formed respectively between the first circuit board and the upper case portion and between the second circuit board and the lower case portion during the molding of the enclosure.

18. The assembly of claim 17 wherein electrically connecting means is disposed between the opposed surfaces of the first and second circuit boards for electrically connecting the first and second circuit boards together.

## Patentansprüche

1. Verfahren zum Montieren einer Leiterplatte an einer Umschließung, das die folgenden Schritte aufweist:
Positionieren einer Leiterplatte in einer Gießform;
Spritzgießen eines Kunstharzes in die Gießform, um eine Umschließung zu bilden, wobei die Leiterplatte so konfiguriert ist, daß das Fließen des Kunststoffs während des Spritzgieß-Schritts einen mechanischen Arretiereingriff zwischen der Leiterplatte und der Umschließung erzeugt; und
Entfernen der montierten Leiterplatte und Umschließung aus der Gießform.

2. Verfahren nach Anspruch 1, wobei wenigstens ein Bereich des Umfangs der Leiterplatte abgeschrägt ist, um den mechanischen Arretiereingriff zu bilden.

3. Verfahren nach Anspruch 1, wobei der mechanische Arretiereingriff dadurch gebildet ist, daß wenigstens ein Bereich des Umfangs der Leiterplatte in eine Nut der Umschließung bis zu einer Tiefe eingesetzt ist, die größer als eine maximale zu erwartende Differenz der Wärmeausdehnung zwischen der Umschließung und der Leiterplatte ist.

4. Verfahren nach Anspruch 1, wobei die Leiterplatte Einschnitte hat, in die der Kunststoff fließt, um den mechanischen Arretiereingriff zu bilden.

5. Verfahren nach Anspruch 4, wobei die Einschnitte umgekehrte Verjüngungen bzw. Hinterschneidungen haben.

6. Verfahren nach Anspruch 1, das folgenden Schritt aufweist: Positionieren von Formstücken an der Leiterplatte in der Gießform, so daß in der Umschließung öffnungen für den Zutritt zu der Leiterplatte geformt werden.

7. Verfahren nach Anspruch 1, wobei die Leiterplatte Löcher hat, in die während des Spritzgieß-Schritts Kunststoff fließt, um den mechanischen Arretiereingriff zu bilden.

8. Verfahren nach Anspruch 7, das den Schritt aufweist: Bilden von Verstärkungsrippen in der Umschließung während des Spritzgieß-Schritts, um die Leiterplatte zu verstärken.

9. Baugruppe aus einer Leiterplatte und einer Umschließung, die folgendes aufweist:
eine Leiterplatte; und
eine an die Leiterplatte angeformte Umschließung aus Formkunststoff,
wobei die Leiterplatte und die Umschließung Bereiche haben, die so konfiguriert sind, daß zwischen der Leiterplatte und der Umschließung während des Spritzgießens der Umschließung ein mechanischer Arretiereingriff gebildet wird.

10. Baugruppe nach Anspruch 9, wobei die Umschließung eine geformte Nut hat, in die ein Bereich des Umfangs der Leiterplatte bis zu einer Tiefe eingesetzt ist, die größer als eine maximale zu erwartende Differenz der Wärmeausdehnung zwischen der Umschließung und der Leiterplatte ist.

11. Baugruppe nach Anspruch 9, wobei wenigstens ein Bereich des Umfangs der Leiterplatte abgeschrägt ist, um den mechanischen Arretiereingriff zu bilden.

12. Baugruppe nach Anspruch 9, wobei die Leiterplatte Einschnitte hat, die mit Kunststoffmaterial der Umschließung ausgefüllt sind, um den mechanischen Arretiereingriff zu bilden.

13. Baugruppe nach Anspruch 12, wobei die Einschnitte umgekehrte Verjüngungen bzw. Hinterschneidungen haben.

14. Baugruppe nach Anspruch 9, wobei die Umschließung geformte Öffnungen hat, um Zugang zu der Leiterplatte vorzusehen.

15. Baugruppe nach Anspruch 9, wobei die Leiterplatte Löcher hat, in die während des Spritzgießschritts Kunststoff fließt, um den mechanischen Arretiereingriff zu bilden.

16. Baugruppe nach Anspruch 15, wobei die Umschließung geformte Verstärkungsrippen zur Verstärkung der Leiterplatte hat.

17. Baugruppe aus zwei Leiterplatten und einer Umschließung, die folgendes aufweist:
eine erste und eine zweite Leiterplatte, die einander gegenüberstehen;
eine Vielzahl von elektronischen Teilen, die an den gegenüberstehenden Oberflächen der ersten und der zweiten Leiterplatte montiert sind; und
eine spritzgegossene Kunststoff-Umschließung, die eine obere Gehäusehälfte, die an die erste Leiterplatte angeformt ist, und eine untere Gehäusehälfte hat, die an die zweite Leiterplatte angeformt ist,
wobei die erste und die zweite Leiterplatte sowie die obere und die untere Gehäusehälfte der Umschließung Bereiche haben, die so konfiguriert sind, daß jeweils zwischen der ersten Leiterplatte und der oberen Gehäusehälfte sowie zwischen der zweiten Leiterplatte und der unteren Gehäusehälfte mechanische Arretiereingriffe während des Spritzgießens der Umschließung gebildet werden.

18. Baugruppe nach Anspruch 17, wobei eine elektrische Verbindungseinrichtung zwischen den gegenüberstehenden Oberflächen der ersten und der zweiten Leiterplatte angeordnet ist, um die erste und die zweite Leiterplatte elektrisch miteinander zu verbinden.

## Revendications

1. Méthode d'assemblage d'une carte de circuit imprimé à une enceinte, comprenant les étapes de :
positionner une carte de circuit imprimé dans un moule;
mouler par injection une résine plastique dans le moule pour former une enceinte, où la carte de circuit est configurée de manière que l'écoulement du plastique pendant l'étape de moulage par injection créé un engagement mécanique bloquant entre la carte de circuit et l'enceinte ; et
retirer la carte de circuit assemblée et l'enceinte du moule.

2. Méthode de la revendication 1, où au moins une portion de la périphérie de la carte de circuit est biseautée pour former l'engagement de blocage mécanique.

3. Méthode de la revendication 1, où l'engagement de blocage mécanique est formé par au moins une portion de la périphérie de la carte de circuit qui est fixée dans une gorge dans l'enceinte par une profondeur plus grande qu'une différence maximale attendue de dilatation thermique entre l'enceinte et la carte de circuit.

4. Méthode de la revendication 1, où la carte de circuit a des encoches dans lesquelles le plastique s'écoule pour former l'engagement de blocage mécanique.

5. Méthode de la revendication 4, où les encoches ont des conicités inverses.

6. Méthode de la revendication 1, comprenant l'étape de placer les pièces du moule contre la carte de circuit dans le moule de manière que les ouvertures pour l'accès à la carte de circuit soient formées dans l'enceinte.

7. Méthode de la revendication 1, où la carte de circuit a des trous dans lesquels le plastique s'écoule pendant l'étape de moulage par injection pour former un engagement de blocage mécanique.

8. Méthode de la revendication 7, comprenant l'étape de former des nervures de renforcement dans l'enceinte pendant l'étape de moulage pour renforcer la carte de circuit.

9. Assemblage d'une carte de circuit et d'une enceinte comprenant :
une carte de circuit ; et
une enceinte moulée en plastique qui est moulée sur la carte de circuit, où la carte de circuit et l'enceinte ont des portions configurées de manière qu'un engagement de blocage mécanique soit formé entre la carte de circuit et l'enceinte pendant le moulage de l'enceinte.

10. Assemblage de la revendication 9, où ladite enceinte a une gorge moulée dans laquelle s'adapte une portion de la périphérie de la carte de circuit sur une profondeur plus grande qu'une différence maximale attendue de dilatation thermique entre l'enceinte et la carte de circuit.

11. Assemblage de la revendication 9, où au moins une portion de la périphérie de la carte de circuit est biseautée pour former l'engagement de blocage mécanique.

12. Assemblage de la revendication 9, où la carte de circuit a des encoches qui sont remplies de la matière plastique de l'enceinte pour former l'engagement de blocage mécanique.

13. Assemblage de la revendication 12, où les encoches ont des conicités inverses.

14. Assemblage de la revendication 9, où l'enceinte a des ouvertures moulées pour laisser un accès à la carte de circuit.

15. Assemblage de la revendication 9, où la carte de circuit a des trous dans lesquels le plastique s'écoule pendant l'étape de moulage par injection pour former l'engagement de blocage mécanique.

16. Assemblage de la revendication 15, où l'enceinte comporte des nervures moulées de renforcement pour renforcer la carte de circuit.

17. Assemblage de deux cartes de circuit et d'une enceinte comprenant :
des première et second cartes de circuit se faisant face ;
un certain nombre de pièces électroniques montées sur les surfaces opposées des première et seconde cartes de circuit ; et
une enceinte moulée en plastique ayant une portion supérieure de boîtier qui est moulée sur la première carte de circuit et une portion inférieure de boîtier moulée sur la seconde carte de circuit,
où les première et seconde cartes de circuit et les portions supérieure et inférieure de boîtier de l'enceinte ont des portions configurées de manière que des engagements mécaniques de blocage se forment respectivement entre la première carte de circuit et la portion supérieure de boîtier et entre la seconde carte de circuit et la portion inférieure de boîtier pendant le moulage de l'enceinte.

18. Assemblage de la revendication 17, où un moyen de connexion électrique est disposé entre les surfaces opposées des première et seconde cartes de circuit pour la connexion électrique des première et seconde cartes de circuit l'une à l'autre.
